# EUROPEAN PATENT APPLICATION

(11) **EP 3 757 997 A1**
(43) Date of publication of application: **30.12.2020**
(21) Application number: 19182043.0
(22) Date of filing: 24.06.2019
(51) Int. Cl.: G11C 11/16

(54) **SPINTRONIC DEVICE WITH A SYNTHETIC ANTIFERROMAGNET HYBRID STORAGE LAYER**

(71) Applicant: IMEC vzw, 3001 Leuven (BE)
(72) Inventor: Couet, Sebastien, 3001 Leuven (BE); Nguyen, Van Dai, 3001 Leuven (BE)
(74) Representative: Roth, Sebastian

(57) **Abstract**

The present invention relates to a spintronic device, which may be a magnetic memory and/or logic device. The spintronic device comprises a tunnel barrier, a storage layer provided on the tunnel barrier, and a seed layer provided on the storage layer. The storage layer includes a first magnetic layer having a first crystallographic orientation provided on the tunnel barrier, a spacer layer provided on the first magnetic layer, a second magnetic layer having a second crystallographic orientation provided on the spacer layer and exchange coupled to the first magnetic layer, an antiferromagnetic coupling layer provided on the second magnetic layer, and a third magnetic layer having the second crystallographic orientation provided on the antiferromagnetic coupling layer and antiferromagnetically coupled to the second magnetic layer.

## Description

### TECHNICAL FIELD

The present invention belongs to the technical field of magnetic memory and/or logic devices. In particular, the invention relates to a spintronic device. The spintronic device comprises a storage layer, which is based on a synthetic antiferromagnet hybrid layer. The spintronic device may, for instance, be a Spin Torque Transfer (STT) Magnetic Random Access Memory (MRAM) device, or a Spin Orbit Torque (SOT) MRAM device. The spintronic device may also be a domain wall logic device, or a Spin Torque Majority Gate (STMG) device.

### BACKGROUND OF THE INVENTION

In magnetic memory and/or logic devices, information is typically stored in a magnetic structure called the "storage layer" (also referred to as the "free layer", compared to another magnetic structure called the "fixed layer" or "reference layer"). Depending on the magnetization of the storage layer - with the fixed layer always having the same magnetization - the storage layer is considered to store a "o" or "1", respectively.

Typically, the storage layer is made of CoFeB, or a similar material, and can incorporate a heavy metal layer such as Ta, W, etc., in order to increase its magnetic anisotropy. This improves the retention characteristic of the storage layer, and thus of the magnetic device as a whole. However, the figure of merit of the storage layer includes not only the retention (Δ) - which should be as high as possible - but also the switching current (Isw) - which should be as low as possible. A storage layer with excellent figure of merit is obviously desired.

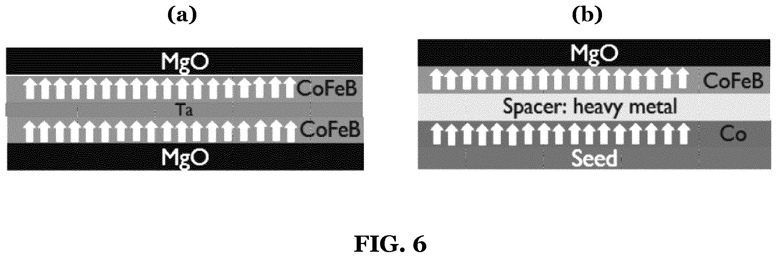

A conventional storage layer design (referred to as "double MgO storage layer") is shown in FIG. 6(a). In this design, two MgO layers are sandwiching two CoFeB layers, which are separated by a Ta layer. One of the MgO layers functions as a tunnel barrier that separates the storage layer (free layer) from the fixed layer (reference layer). The design of FIG. 6(a) relies on interfacial Perpendicular Magnetic Anisotropy (PMA) originating from the CoFeB/MgO interface. This is a weakness of the design, and particularly prevents the realization of a STMG device and/or racetrack memory device with this design.

The weakness has its cause particularly in the manufacturing process of such a STMG device, which includes a particular pillar patterning step. This pillar patterning step requires etching the material stack, and stopping in a controlled manner directly on the MgO layer (i.e. just above the storage layer for a top-pinned device). Etching all the way to the MgO layer is necessary to avoid shorting current paths between the pillars. However, during the etch process, etching ions will inevitably penetrate a few nm deep into the material. Thus, damages may be produced, before the MgO layer is reached, which can lead to a collapse of the CoFeB PMA.

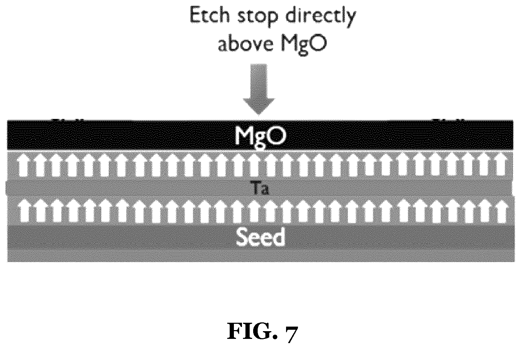

One possible way to circumvent this is to fabricate a storage layer that contains material with intrinsic PMA, which will be more resistant to potential etch damage. Such a conventional storage layer design (referred to as "hybrid storage layer") is shown in FIG. 6(b). In the design of FIG. 6(b), a CoFeB layer is provided on the MgO tunnel barrier, a spacer layer is provided on the CoFeB layer, a Co layer is provided on the spacer layer, and a seed layer is provided on the Co layer. The etch stop condition, which is necessary for producing a STMG device, is illustrated in FIG. 7. A drawback of this design is that a quite high switching current is required, because of the higher anisotropy materials that are used.

### SUMMARY OF THE INVENTION

In view of the above-mentioned challenges and the disadvantages of conventional designs, embodiments of the present invention aim to provide an improved spintronic device. An objective is in particular to provide a spintronic device with a storage layer having a high figure of merit. That means, the storage layer should show an increased retention and/or reduced switching current. The storage layer should further be more robust to etch stop conditions as mentioned above. Another goal is to design the storage layer such that the material stack can be optimized for different sizes of the spintronic device.

The objective is achieved by the embodiments of the invention provided in the enclosed independent claims. Advantageous implementations of these embodiments are defined in the dependent claims.

The embodiments of the invention rely on a synthetic antiferromagnet hybrid storage layer design. Thereby, embodiments of the invention can include both bottom-pinned and top-pinned spintronic devices. For a top-pinned device, the storage layer is arranged at the bottom of the full device (e.g. MRAM) stack. For a bottom-pinned device, the storage layer is arranged at the top of the stack. The top-pinned device geometry is currently used/evaluated to realize spin logic devices, such as the STMG device. It is also the more likely/expected geometry for high-density memory concepts, such as a racetrack memory device. These types of devices also require that magnetic information is transported via magnetic domain wall motion, hence putting additional requirements on the properties of the storage layer, such as high domain wall speed, and robustness against domain wall pinning.

A first aspect of the invention provides a spintronic device, comprising: a tunnel barrier; a storage layer provided on the tunnel barrier, wherein the storage layer includes a first magnetic layer having a first crystallographic orientation provided on the tunnel barrier, a spacer layer provided on the first magnetic layer, a second magnetic layer having a second crystallographic orientation provided on the spacer layer and exchange coupled to the first magnetic layer, an antiferromagnetic coupling layer provided on the second magnetic layer, a third magnetic layer having the second crystallographic orientation provided on the antiferromagnetic coupling layer and antiferromagnetically coupled to the second magnetic layer; and a seed layer provided on the third magnetic layer.

In this document, a layer being "provided on" another layer may either mean that the layer is arranged "below" (for a top-pinned device) or "above" (for a bottom-pinned device) the other layer. Thereby, the terms "below"/"above" or "bottom"/"top" relate to layers of the material stack, in particular to the fabrication/growth direction of these layers. In any case, "provided on" means that the layer is in contact with the other layer. For instance, the layer may be (epitaxially) grown on the other layer.

It is also noted that the seed layer may be a part of the storage layer, or may be a separate layer provided on the storage layer. For instance, in case that the spintronic device is a racetrack memory device, or a domain wall logic device, the seed layer may belong to the storage free layer.

In the spintronic device of the first aspect, due to the antiferromagnetic alignment in the storage layer, a smaller net magnetic moment is obtained. Hence, the storage layer is much less sensitive to stray fields induced by the fixed layer. In particular, the storage layer can be realized with almost exactly zero net magnetic moment. This, for instance, allows the material stack to be optimized for spintronic devices of largely different sizes. Further, this allows increasing the total volume of the storage layer, thus enabling a significant increase in the retention (Δ), e.g. compared to the hybrid free layer design shown in FIG. 6(b). Further, this also allows reducing the required switching current (Isw), likely because of a second torque originating from the second magnetic layer. Overall, the figure of merit of the storage layer of the spintronic device of the first aspect is strongly improved, i.e. it has a higher Δ at a lower Isw. Accordingly, an improved spintronic device is provided.

Moreover, especially for logic or domain wall movement applications, the spintronic device of the first aspect can provide a thicker storage layer with additional intrinsic PMA material, which makes it more robust to the above-described etch stop conditions. Thus, fabricating a STMG device is feasible with the proposed storage layer design.

Further, due to a partial cancellation of the dipolar field, domain walls in the storage layer of the spintronic device of the first aspect tend to be narrower than in a conventional device/storage layer. This is beneficial for the design of a racetrack memory device with ultrahigh density. Also, much higher domain wall speeds are enabled (i.e. a faster operation is possible), due to the existence of an additional exchange coupling torque, which is proportional to the strength of the antiferromagnetic coupling between the magnetic layers of the storage layer.

In an implementation of the spintronic device, the first magnetic layer is a CoFeB or FeB layer.

In an implementation of the spintronic device, the second magnetic layer is a Co-based layer.

The "Co-based" second magnetic layer can be a Co layer. However, it can generally be a layer based on Co, for instance, a CoNi, CoPt, or CoFe layer, or a laminate or an alloy thereof.

In an implementation of the spintronic device, the third magnetic layer is a Co-based layer.

The "Co-based" third magnetic layer can be a Co layer. However, it can generally be a layer based on Co, for instance, a CoNi, CoPt, CoPt, or CoFe layer, or a laminate or an alloy thereof.

In an implementation of the spintronic device, the first crystallographic orientation is a (100) orientation, and/or the second crystallographic orientation is a (111) orientation.

Generally, the first and second crystallographic orientations are different.

In an implementation of the spintronic device, a thickness of the first magnetic layer and/or of the second magnetic layer is in a range of 0.4-1.5 nm.

In an implementation of the spintronic device, the antiferromagnetic coupling layer is a Ru layer, an Ir layer, or a Rh layer.

In particular, the antiferromagnetic coupling may be an antiferromagnetic Ruderman-Kittel-Kasuya-Yosida (RKKY) coupling. The RKKY coupling generates an antiferromagnetic arrangement of spins in the second magnetic layer and spins in the third magnetic layer, respectively. The strength of this antiferromagnetic RKKY coupling is a function of the thickness of the antiferromagnetic coupling layer arranged between the second and third magnetic layer. For specific thicknesses of the antiferromagnetic coupling layer, the RKKY coupling strength shows peaks.

Here, the Ru layer may particularly be a Ru (0.4, 0.8) layer and/or the Ir layer may particularly be an Ir (0.5, 0.9) layer. Thereby, "0.4" and "0.8" denote thicknesses of the Ru layer in nm, at which peaks appear in the antiferromagnetic RKKY coupling. Likewise, "0.5" and "0.9" denote thicknesses of the Ir layer in nm, at which such coupling peaks appear. In particular, the given thicknesses are related to the first peak and the second peak in the strength of the antiferromagnetic RKKY coupling, respectively. Preferably, the first peak or the second peak is employed, i.e. the antiferromagnetic coupling layer is preferably either made of Ru having a thickness of 0.4 nm or 0.8 nm, or is made of Ir having a thickness of 0.5 nm or 0.9 nm. However, it is also possible to employ the third peak or the fourth peak (or even other peaks), namely by providing even thicker antiferromagnetic coupling layers made of Ru or Ir, respectively. By using RKKY coupling, i.e. an RKKY antiferromagnetic coupling layer, an antiferromagnetic coupling with sufficient strength can be achieved, such that both parts of the storage layer will reverse together.

In an implementation of the spintronic device, the spacer layer is configured to provide a texture breaking between the different crystallographic orientations of the first magnetic layer and the second magnetic layer having, respectively, and/or the spacer layer is a heavy-metal layer or a heavy-metal transition-metal alloy layer.

In an implementation of the spintronic device, the seed layer is a heavy-metal layer or a topological insulator, and/or the seed layer is a SOT generating layer.

In particular, the heavy-metal layer may be Ta, W, or preferably Pt. The topological insulator may be Bi2Se3 or BiₓSb₁₋ₓ.

In an implementation of the spintronic device, the tunnel barrier is a MgO-based layer.

The "MgO-based" tunnel barrier can be a MgO layer. However, it can generally be a layer based on MgO, for instance, a MgGaOx or MgAlOx layer. Ox can e.g. be O, O₂, O₃, etc.

In an implementation the spintronic device further comprises a fixed layer provided on an opposite side of the tunnel barrier than the storage layer.

The fixed layer may be a CoFeB layer.

In an implementation of the spintronic device, the spintronic device is a three-terminal device, and two terminals are connected to the seed layer.

A third terminal may be connected to the fixed layer. The spintronic device may, however, also be a two-terminal device, in which one terminal may be connected to the fixed layer and one terminal may be connected to the seed layer.

In an implementation of the spintronic device, the spintronic device is a memory device, in particular is a STT MRAM, device, a SOT MRAM device, or a magnetic racetrack memory device.

In an implementation of the spintronic device, the spintronic device is a domain wall logic device, in particular is a STMG device.

A second aspect of the invention provides a method for manufacturing a spintronic device, the method comprising: providing a tunnel barrier; providing a storage layer on the tunnel barrier, wherein providing the storage layer includes: providing a first magnetic layer having a first crystallographic orientation on the tunnel barrier; providing a spacer layer on the first magnetic layer; providing a second magnetic layer having a second crystallographic orientation on the spacer layer, wherein the second magnetic layer is exchange coupled to the first magnetic layer; providing an antiferromagnetic coupling layer on the second magnetic layer; providing a third magnetic layer having the second crystallographic orientation on the antiferromagnetic coupling layer, wherein the third magnetic layer is antiferromagnetically coupled to the second magnetic layer; and the method further comprises providing a seed layer on the third magnetic layer.

The method of the second aspect can be further developed according to the implementations described above for the spintronic device of the first aspect. The method of the second aspect thus achieves the same advantages as the spintronic device of the first aspect and its implementations.

### BRIEF DESCRIPTION OF THE DRAWINGS

The above described aspects and implementations are explained in the following description of embodiments with respect to the enclosed drawings:
- FIG. 1: shows a spintronic device according to an embodiment of the invention.
- FIG. 2: shows an exemplary spintronic device according to an embodiment of the invention.
- FIG. 3: shows a spintronic device according to an embodiment of the invention, for STT-MRAM application.
- FIG. 4: shows a spintronic device according to an embodiment of the invention, for SOT-MRAM application.
- FIG. 5: shows a spintronic device according to an embodiment of the invention, for spin logic and racetrack memory applications.
- FIG. 6: shows conventional spintronic devices in (a) and (b), respectively.
- FIG. 7: shows an etch stop in patterning a conventional spintronic device.

### DETAILED DESCRIPTION OF EMBODIMENTS OF THE INVENTION

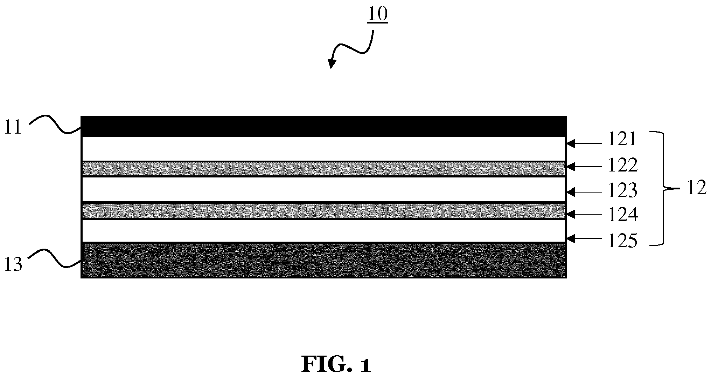

FIG. 1 shows a spintronic device 10 according to an embodiment of the invention. The spintronic device 10 may be a logic device or a memory device. In particular, the spintronic device 10 may be a STT-MRAM device, a SOT-MRAM device, a magnetic racetrack memory device, a domain wall logic device, or a STMG device.

The spintronic device 10 comprises generally a tunnel barrier 11, a storage layer 12, and a seed layer 13. The storage layer 12 is arranged between the tunnel barrier 11 and the seed layer 13. The storage layer 12 is thus provided on the tunnel barrier 11, and the seed layer 13 may be provided on the storage layer 12. The seed layer 13 may alternatively be a part of the storage layer 12 (for some device configurations).

The storage layer 12 includes, in particular, a first magnetic layer 121 provided on the tunnel barrier 11. The first magnetic layer 121 has a first crystallographic orientation. Further, the storage layer 12 comprises a spacer layer 122 provided on the first magnetic layer 121, and a second magnetic layer 123 provided on the spacer layer 122. The second magnetic layer 123 has a second crystallographic orientation, particularly a crystallographic orientation different than the first magnetic layer 121. The second magnetic layer 123 is furthermore exchange coupled (magnetic exchange interaction) to the first magnetic layer 121, i.e. through the spacer layer 122.

Further, the storage layer 12 includes an antiferromagnetic coupling layer 124 provided on the second magnetic layer 123, and a third magnetic layer 125 provided on the antiferromagnetic coupling layer 124. The third magnetic layer 125 has the second crystallographic orientation, i.e. the same crystallographic orientation as the second magnetic layer 123. The third magnetic layer 125 is antiferromagnetically coupled to the second magnetic layer 123, i.e. via the antiferromagnetic coupling layer 124.

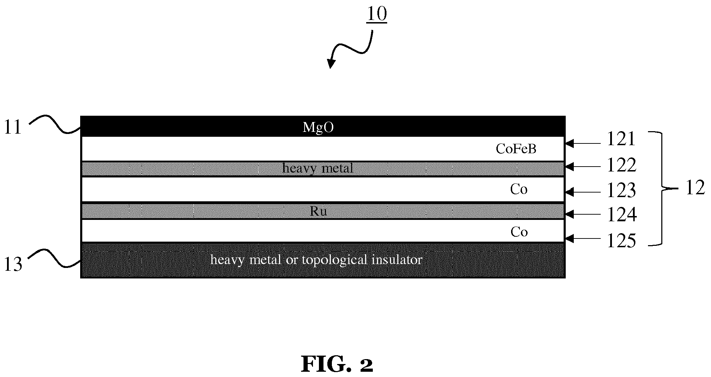

FIG. 2 shows an exemplary spintronic device 10 according to an embodiment of the invention, which builds on the spintronic device 10 shown in FIG. 1. In particular, FIG. 2 shows a more detailed implementation of the spintronic device 10 of FIG. 1.

Starting from the MgO tunnel barrier 11, the storage layer 12 of the spintronic device 10 of FIG. 2 is in particular composed of:
- A CoFeB or FeB layer as the first magnetic layer 121, in order to provide the Tunnel Magnetoresistance (TMR) effect for device read, and the spin transfer torque (STT) effect for device write. A thickness range for the first magnetic layer 121 may be 0.4 to 1.4 nm.
- The spacer layer 122 also called a texture breaking layer. Its role is to provide a texture breaking between the different crystallographic orientations of the first magnetic layer 121 and of the second magnetic layer 123. In particular, a texture breaking between the (100)-oriented CoFeB and (111)-oriented Co layer as the second magnetic layer 123 is provided. The spacer layer 122 typically comprises a heavy metal layer, such as Ta, W, or Mo. Alternatively, it may comprise a heavy metal-transition metal alloy, such as TaCoFeB, TaFe, TaCoFe, TaCo, or WCoFeB.
- A first Co layer as the second magnetic layer 123, which is exchange coupled to the CoFeB layer 121 (over the spacer layer 122). A thickness range for the second magnetic layer 123 may be 0.4 to 1.5 nm.
- The antiferromagnetic coupling layer 124, which is typically a Ru layer or Ir layer, particularly Ru (0.4, 0.8), or Ir (0.5, 0.9), or a Rh layer.
- A second Co layer as the third magnetic layer 125, which is antiferromagnetically coupled to the first Co layer 123 via the coupling layer 124.
- The seed layer 13, which may support the Co PMA, may provide Dzyaloshinskii-Moriya interaction and SOT on domain wall (DW) motion. The seed layer 13 may comprise a heavy metal layer, e.g. Pt, Ta, or W, layer. It could also be a topological insulator such as Bi2Se₃ or BiₓSb₁₋ₓ.

FIG. 2 shows specifically a MgO tunnel barrier 11, a CoFeB layer 121 provided on the MgO tunnel barrier 11, a heavy metal layer 122 provided on the CoFeB layer 121, a first Co layer 123 provided on the heavy metal layer 122, a Ru layer 124 provided on the first Co layer 123, a second Co layer 125 provided on the Ru layer 124, and a heavy metal or insulator seed layer 13 provided on the second Co layer 125. However, different combinations of materials according to the above-provide exemplary materials are possible.

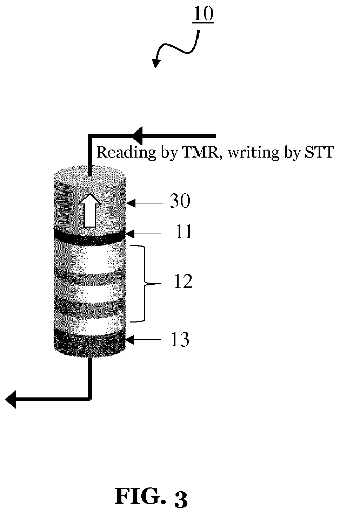

FIG. 3 shows a spintronic device 10 according to an embodiment of the invention, for a STT-MRAM application. The spintronic device 10 of FIG. 3 is in particular a two-terminal device. One terminal is connected to the seed layer 13, and the other terminal is connected to a fixed layer 30.

The spintronic device 10 includes the tunnel barrier 11, which is provided on the fixed layer 30 and separates it from the storage layer 12. That means the fixed layer 30 is provided on the other side of the tunnel barrier 11 than the storage layer 12. The storage layer 12 is provided on the tunnel barrier 11 and includes the first magnetic layer 121, spacer layer 122, second magnetic layer 123, antiferromagnetic coupling layer 124, and third magnetic layer 125, as described above with respect to FIG. 1 and/or FIG. 2. The spintronic device 10 further includes the seed layer 13, which may also be implemented as described above.

In the spintronic device 10 of FIG. 3, writing into the storage layer 12 can be carried out by means of STT (sending a spin-polarized switching current Isw through fixed layer 30 and tunnel barrier 11 into the storage layer, as in a conventional STT-MRAM), and reading from the storage layer 12 can carried out by means of TMR, as in a conventional MRAM.

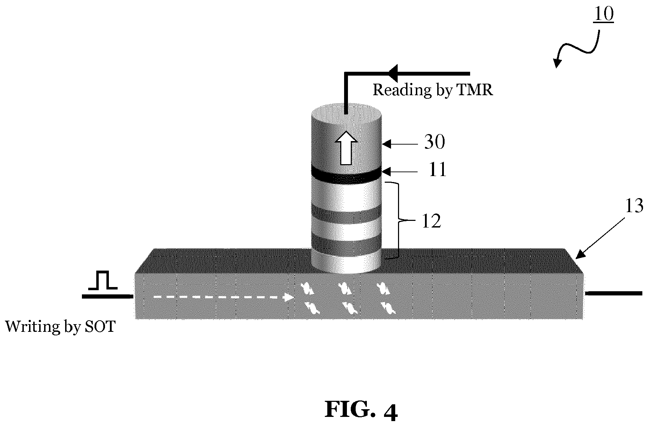

FIG. 4 shows a spintronic device 10 according to an embodiment of the invention, for a SOT-MRAM application. The spintronic device 10 of FIG. 4 is in particular a three-terminal device. Two terminals are connected to the seed layer 13, and the third terminal is connected to a fixed layer 30.

The spintronic device 10 includes the tunnel barrier 11, which is provided on the fixed layer 30 and separates it from the storage layer 12. The storage layer 12 is provided on the tunnel barrier 11 and includes the first magnetic layer 121, spacer layer 122, second magnetic layer 123, antiferromagnetic coupling layer 124, and third magnetic layer 125, as described above with respect to FIG. 1 and/or FIG. 2. The spintronic device 10 further includes the seed layer 13, which may also be implemented as described above. The seed layer 13 may serve as basis carrying the patterned (pillar-patterned) storage layer 12, tunnel barrier 11 and fixed layer 30.

In the spintronic device 10 of FIG. 4, writing into the storage layer 12 can be carried out by means of SOT (via the two terminals connected to the seed layer 13). This may be supported by a high SOT efficiency layer as the seed layer 13, like Pt, Ta, W or a topological insulator layer. Reading from the storage layer 12 can be carried out by means of TMR, as in FIG. 3, via the terminal connected to the fixed layer 30.

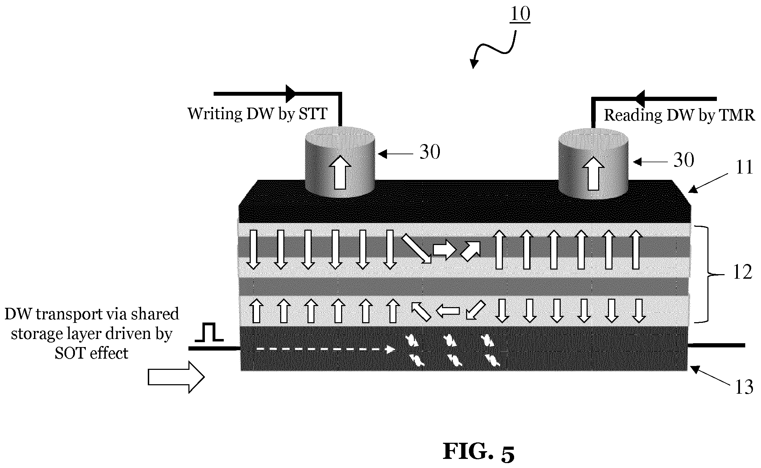

FIG. 5 shows a spintronic device 10 according to an embodiment of the invention, for spin logic and racetrack memory applications. The spintronic device 10 of FIG. 5 is in particular a three-terminal device (or even a more-than-three-terminal device). Two terminals are connected to the seed layer 13, and one or more third terminals are each connected to a fixed layer 30. For instance, two third terminals may be connected each to a separate pillar of fixed layer 30 (separated by patterning), as shown in FIG. 5.

The spintronic device 10 includes the tunnel barrier 11, which is provided on the (pillars of) fixed layer(s) 30 and separates it/them from the storage layer 12. That is, the storage layer 12 may be shared between different pillars of fixed layer 30.

The storage layer 12 is provided on the tunnel barrier 11 and includes the first magnetic layer 121, spacer layer 122, second magnetic layer 123, antiferromagnetic coupling layer 124, and third magnetic layer 125 as described above with respect to FIG. 1 and/or FIG. 2. The spintronic device 10 further includes the seed layer 13, which may also be implemented as described above. Since the seed layer 13 may also be shared between different pillars of fixed layer 13, it may be considered to be a part of the (shared) storage layer 12 in this spintronic device 10.

In the spintronic device 10 of FIG. 5, writing DW into the storage layer 12 can be carried out by means of STT (e.g. via one terminal connected to the fixed layer 30, particularly to one pillar of fixed layer 30). Reading DW can be carried out by TMR (e.g. via another terminal connected to the fixed layer 30, particularly to another pillar of fixed layer 30). DW transport can be carried out via shared the storage layer 12, driven by a SOT effect of the shared seed layer 13. For this, the two terminals connected to the seed layer 13 may be used. The seed layer 13 may thus be a SOT generating layer, for instance, a Pt, Ta, W or topological insulator layer.

In summary, the embodiments of the spintronic device 10 according to the invention are useful for memory applications and for logic applications.

Memory applications may specifically include:
- A STT-MRAM pillar device with a higher retention (Δ) and a lower switching current (Isw), less sensitivity to stray fields, and eliminated offset fields (thus enabling different device sizes/masks).
- A SOT-MRAM device enabling a higher Δ, high switching speeds, eliminated offset field, and having less sensitivity to stray fields.
- A magnetic racetrack memory device enabling higher density and higher speed DW motions with TMR read and STT write.

Logic applications may specifically include:
- A STMG device with a lower Isw, higher domain wall speeds, and more robustness to pillar etching conditions.
- Other logic devices making use of an extended storage layer 12.

In each embodiment, the spintronic device 10 according to the invention thus benefits from the storage layer 12, designed as a synthetic antiferromagnet hybrid storage layer.

## Claims

1. Spintronic device (10), comprising:
a tunnel barrier (11);
a storage layer (12) provided on the tunnel barrier (11), wherein the storage layer (12) includes
- a first magnetic layer (121) having a first crystallographic orientation provided on the tunnel barrier (11),
- a spacer layer (122) provided on the first magnetic layer (121),
- a second magnetic layer (123) having a second crystallographic orientation provided on the spacer layer (122) and exchange coupled to the first magnetic layer (121),
- an antiferromagnetic coupling layer (124) provided on the second magnetic layer (123),
- a third magnetic layer (125) having the second crystallographic orientation provided on the antiferromagnetic coupling layer (124) and antiferromagnetically coupled to the second magnetic layer (123); and
a seed layer (13) provided on the third magnetic layer (125).

2. Spintronic device (10) according to claim 1, wherein:
the first magnetic layer (121) is a CoFeB or FeB layer.

3. Spintronic device (10) according to claim 1 or 2, wherein:
the second magnetic layer (123) is a Co-based layer.

4. Spintronic device (10) according to one of the claims 1 to 3, wherein:
the third magnetic layer (125) is a Co-based layer.

5. Spintronic device (10) according to one of the claims 1 to 4, wherein:
the first crystallographic orientation is a (100) orientation, and/or
the second crystallographic orientation is a (111) orientation.

6. Spintronic device (10) according to one of the claims 1 to 5, wherein:
a thickness of the first magnetic layer (121) and/or of the second magnetic layer (123) is in a range of 0.4-1.5 nm.

7. Spintronic device (10) according to one of the claims 1 to 6, wherein:
the antiferromagnetic coupling layer (124) is a Ru layer, an Ir layer, or a Rh layer.

8. Spintronic device (10) according to one of the claims 1 to 7, wherein:
the spacer layer (122) is configured to provide a texture breaking between the different crystallographic orientations of the first magnetic layer (121) and the second magnetic layer (123), respectively, and/or the spacer layer (122) is a heavy-metal layer or a heavy-metal transition-metal alloy layer.

9. Spintronic device (10) according to one of the claims 1 to 8, wherein:
the seed layer (13) is a heavy-metal layer or a topological insulator, and/or
the seed layer (13) is a spin-orbit-torque, SOT, generating layer.

10. Spintronic device (10) according to one of the claims 1 to 9, wherein:
the tunnel barrier (11) is a MgO-based layer.

11. Spintronic device (10) according to one of the claims 1 to 10, further comprising:
a fixed layer (30) provided on an opposite side of the tunnel barrier (11) than the storage layer (12).

12. Spintronic device (10) according to one of the claims 1 to 11, wherein:
the spintronic device (10) is a three-terminal device, and
two terminals are connected to the seed layer (13).

13. Spintronic device (10) according to one of the claims 1 to 12, wherein:
the spintronic device (10) is a memory device, in particular is a spin torque transfer, STT, magnetic random access memory, MRAM, device, a SOT MRAM device, or a magnetic racetrack memory device.

14. Spintronic device (10) according to one of the claims 1 to 12, wherein:
the spintronic device is a domain wall logic device, in particular is a spin torque majority gate, STMG, device.
